# EUROPÄISCHE PATENTANMELDUNG

(11) **EP 4 378 312 A1**
(43) Veröffentlichungstag der Anmeldung: **05.06.2024**
(21) Anmeldenummer: 22210623.9
(22) Anmeldetag: 30.11.2022
(51) Int. Cl.: A01N 59/20, C23C 14/16, A01N 25/34, C23C 28/02, F24F 8/24

(54) **BESCHICHTETES STAHLBAND MIT ANTIMIKROBIELLER KUPFERSCHICHT FÜR LUFTTECHNISCHE ANLAGEN**

(71) Anmelder: voestalpine Stahl GmbH, 4020 Linz (AT)
(72) Erfinder: Stellnberger, Karl-Heinz, 4020 Linz (AT); Burgstaller, Wolfgang, 4030 Linz (AT)
(74) Vertreter: Wildhack & Jellinek Patentanwälte

(57) **Zusammenfassung**

Die Erfindung bezieht sich auf technische Anlagen und betrifft eine Beschichtung für ein Stahlband (1), ein beschichtetes Stahlband (1), ein Verfahren zur Herstellung der Beschichtung und eine lufttechnische Anlage umfassend die Beschichtung. Dabei ist vorgesehen, dass die Beschichtung eine Zinkschicht (2) zur Anordnung direkt auf der Oberfläche des Stahlbandes (1) und eine auf der Zinkschicht (2) angeordnete Kupferschicht (3) aufweist, wobei die Kupferschicht (3) Durchbrechungen aufweist. Die Zinkschicht (2) ist dabei nur teilweise von der Kupferschicht (3) bedeckt.

## Beschreibung

Die Erfindung betrifft eine antimikrobielle Beschichtung für ein Stahlband, ein beschichtetes Stahlband, ein Verfahren zur Herstellung der Beschichtung und Anwendungen von antimikrobiellen Beschichtungen, wie z.B. raumlufttechnische Anlagen (RLT- Anlagen).

Lufttechnische Anlagen dienen der Steuerung der Luftqualität in Räumen. Sie werden in vielen unterschiedlichen Bereichen verbaut, wobei lufttechnische Anlagen sowohl für einzelne Räume als auch für ganze Gebäude oder bauliche Anlagen, wie U-Bahnsysteme vorgesehen sein können. Der Umbau oder die Erneuerung einer lufttechnischen Anlage ist sehr aufwendig, da einerseits die Räume in der Umbauphase nicht voll genutzt werden können und andererseits hohe Investitionskosten entstehen. Lufttechnische Anlagen haben daher üblicherweise eine lange Nutzungsdauer von zumindest 20 Jahren.

Lufttechnische Anlagen umfassen zumindest einen Innenraum zur Luftführung, durch den ein Luftstrom in einen Raum oder aus einem Raum geführt werden kann. Zur Erzeugung eines geregelten Luftstroms ist zumeist ein Ventilator vorgesehen. Weiters können Filter, Befeuchter, Entfeuchter, Heizelemente, Kühlelemente oder andere funktionelle Elemente vorgesehen sein, um die gewünschte Luftqualität zu erreichen.

Ein wesentliches Qualitätskriterium zur Beurteilung der Luftqualität ist die enthaltene Menge an Krankheitserregern in der Luft. So können in der Luft befindliche Bakterien, Pilze, Sporen und Viren durch lufttechnische Anlagen verbreitet werden. Lufttechnische Anlagen unterliegen daher vor allem im öffentlichen Raum, im Medizin- und Nahrungsmittelbereich sehr strengen Hygiene-Kontrollen. Entspricht die Luftqualität nicht den geforderten Grenzwerten, kann dies Schließungen und somit große wirtschaftliche Schäden nach sich ziehen. Es ist daher notwendig, bei der Wartung der Anlagen darauf zu achten, dass es im Innenraum der lufttechnischen Anlage nicht zu Ablagerungen kommt, in denen sich Krankheitserreger festsetzen oder sogar vermehren könnten. Die Reinigung der Anlagen ist jedoch oft sehr aufwendig und nur mit spezieller Ausrüstung möglich. Da die lufttechnische Anlage während der Wartung nicht genutzt werden kann, sollte die Reinigung dennoch möglichst rasch erfolgen können.

Üblicherweise werden lufttechnische Anlagen aus verzinktem Stahl hergestellt. Allerdings können Ablagerungen von Viren, Bakterien und Pilzen im Betrieb von RLT-Anlagen nicht verhindert werden.

Zwar sind Stahlzusammensetzungen bekannt, die antimikrobiell wirken, wie beispielsweise JP 2000 192259 A zeigt. Diese sind jedoch teuer und anfällig für Korrosion. Daher sind derartige Stähle nicht für die Verwendung in lufttechnischen Anlagen geeignet.

Weiters sind Beschichtungen bekannt, die antimikrobiell wirken: WO 2002 087339 offenbart beispielsweise ein Metallblech, das mit einem Polymer beschichtet wird, welches antimikrobiell wirksame anorganische Partikel enthält. Da in einer solchen Anordnung allerdings die antimikrobiell wirkenden Partikel in dem Polymer eingelagert sind, kann nur ein sehr geringer Anteil der Partikel an der Oberfläche der antimikrobiellen Beschichtung wirksam werden. Die Wirkdauer einer solchen Beschichtung ist daher auf wenige Jahre beschränkt. Auch die Haftung von Polymerbeschichtungen ist nicht ausreichend für die lange Einsatzdauer in lufttechnischen Anlagen. Für den Einsatz in lufttechnischen Anlagen sind derartige Beschichtungen daher nicht geeignet.

Weiters sind aufgrund der Größe und Form von lufttechnischen Anlagen auch Beschichtungen nicht geeignet, die nur auf Stückgut applizierbar sind.

Die Aufgabe der Erfindung besteht daher darin, eine Möglichkeit zu schaffen, technische Anlagen, im Besonderen lufttechnische Anlagen, oder Elemente zur Herstellung derartiger Anlagen über lange Zeiträume, möglichst über ihre gesamte Bestandsdauer, zuverlässig gegen mikrobielle Verunreinigungen zu schützen und dauerhaft eine hohe Luftqualität gewährleisten zu können, während gleichzeitig der Wartungs- und Reinigungsaufwand reduziert werden soll.

Diese Aufgabe wird gelöst durch eine Beschichtung für Metall, insbesondere für ein Stahlband, umfassend eine Zinkschicht zur Anordnung direkt auf der Oberfläche des Stahlbandes und eine auf der Zinkschicht angeordnete Kupferschicht, wobei die Kupferschicht Durchbrechungen aufweist. Die Zinkschicht ist also nur teilweise von Kupfer bedeckt.

Die Zinkschicht enthält Zink, sodass es in Kontakt mit reiner Luft nahezu sofort zur Bildung von Zinkoxid kommt. Beispielsweise kann die Zinkschicht aus im Wesentlichen reinem Zink oder einer Zinklegierung bestehen, wobei das Zink aus der Zinkschicht mit dem Luftsauerstoff reagiert. Die Kupferschicht enthält Kupfer, sodass es in Kontakt mit Luft zur Bildung von Kupferoxid kommt. Sowohl Zinkoxid als auch Kupferoxid haben antimikrobielle Eigenschaften. Gleichzeitig werden durch das Zusammenwirken von Zink und Kupfer das Metall, insbesondere Stahl, und die Beschichtung vor Korrosion geschützt.

Bei einer Abnutzung reagieren die dann freiliegenden Metalle wieder mit der Luft und der Korrosionsschutz wird rasch wiederhergestellt. So kann eine lange Haltbarkeit und eine hohe Wirkdauer gewährleistet werden. Die Aufbringung der Beschichtung auf ein durchlaufendes Metallband ist möglich, sodass eine kostengünstige Herstellung großer Flächen möglich ist. Die Beschichtung ist daher für den Einsatz in lufttechnischen Anlagen geeignet und trägt dauerhaft zu einer guten Luftqualität und zur Volksgesundheit bei.

Vorteilhafte Merkmale sind in den abhängigen Ansprüchen beschrieben.

Um das Zusammenwirken von Zink und Kupfer zu verbessern, kann vorgesehen sein, dass die Kupferschicht direkt auf der Zinkschicht angeordnet ist. Dies kann die antimikrobielle Wirkung der Beschichtung weiter verbessern.

Wenn die Beschichtung bereits mit Luft in Kontakt war, kann auf der Oberfläche der Beschichtung Kupferoxid und/oder Zinkoxid ausgebildet sein. Dies wirkt besonders gut antimikrobiell.

Durch einen Kontakt der Beschichtung mit Luft, kann in den Durchbrechungen Zinkoxid und/oder Kupferoxid ausgebildet sein. Dies verbessert die antimikrobiellen Eigenschaften.

Um die antimikrobielle Wirksamkeit zu verbessern, kann vorgesehen sein, dass die Durchbrechungen schwammstrukturförmig ausgebildet sind. In diesem Fall erstrecken sich teilweise durchgehende Gänge durch die Kupferschicht, in denen die Oberfläche der Beschichtung von der Zinkschicht gebildet ist, bzw. ist die Kupferschicht inselgruppenförmig auf der Zinkschicht angeordnet. Dies kann beispielsweise durch Aufbringung einer porösen Kupferschicht erreicht werden. Es kann daher zur Verbesserung der antimikrobiellen Wirksamkeit vorgesehen sein, dass die Kupferschicht löchrig oder porös ausgebildet ist.

Die Wirksamkeit ist besonders gut, wenn die Durchbrechungen gleichmäßig in der Kupferschicht verteilt angeordnet sein. Eine gleichmäßige Verteilung liegt dann vor, wenn die Durchbrechungen so angeordnet sind, dass verschiedene Bereiche der Beschichtung mit gleicher Größe, im Wesentlichen die gleiche Fläche an Durchbrechungen aufweisen.

Um eine besonders gute Wirksamkeit zu erreichen, kann vorgesehen sein, dass die Durchbrechungen regelmäßig in der Kupferschicht verteilt angeordnet sind. Um eine regelmäßige Verteilung der Durchbrechungen zu erreichen, kann beispielsweise vorgesehen sein, dass die Zinkschicht vor Aufbringung der Kupferschicht teilweise abgedeckt oder maskiert wird, insbesondere durch ein feines Gitter bzw. Netz. Besonders geeignet sind dabei Maschenweiten von 0,01 mm bis 5 mm.

Generell ist es vorteilhaft, wenn die Durchbrechungen nicht zu große Einzelflächen aufweisen. Durchbrechungen mit einem Durchmesser im Bereich von etwa 1 µm bis 500 µm fördern die Bildung von Zinkoxid im Bereich der Durchbrechungen und unterstützt daher die antimikrobiellen Eigenschaften.

Eine besonders gute Wirksamkeit wird erreicht, wenn die Fläche der Durchbrechungen 10 % bis 80 %, insbesondere 40 % bis 70 %, vorzugsweise 45 % bis 55 %, der Oberfläche der Beschichtung aufweist.

Die antimikrobielle Eigenschaft der Beschichtung ist also besonders ausgeprägt, wenn 20 % bis 90 %, insbesondere 30 % bis 60 %, vorzugsweise 45% bis 55 % der Oberfläche der Zinkschicht von der Kupferschicht bedeckt sind.

Dabei ist es besonders vorteilhaft, wenn die Kupferschicht Bereiche mit einem Durchmesser von 0,1 mm bis 5 mm aufweist, insbesondere mit einem Durchmesser von 0,5 mm bis 2 mm, aufweist.

Eine kostengünstige Beschichtung mit langer Haltbarkeit kann bereitgestellt werden, wenn die Kupferschicht eine Schichtdicke von 30 nm bis 5000 nm, bevorzugt 50 nm bis 1500 nm, insbesondere von 100 nm bis 1300 nm, besonders bevorzugt von 250 nm bis 900 nm, aufweist.

Um eine lange Haltbarkeit und einen guten Korrosionsschutz bereitzustellen, kann vorgesehen sein, dass Zinkschicht eine Schichtdicke von 5 µm bis 25 µm, insbesondere von 7 µm bis 10 µm, aufweist.

Ein weiterer Aspekt der Erfindung betrifft ein Stahlband umfassend eine zuvor beschriebene Beschichtung. Dabei ist die Zinkschicht direkt auf dem Stahlband angeordnet. Ein derartiges Stahlband kann kostengünstig hergestellt werden und weist eine lange Haltbarkeit auf, wobei die mikrobielle Beschichtung eine lange Haltbarkeit und Wirkdauer erreicht.

Noch ein weiterer Aspekt der Erfindung betrifft eine lufttechnische Anlage umfassend eine zuvor beschriebene Beschichtung und/ oder ein Element aus einem zuvor beschriebenen Stahlband. Die Beschichtung, insbesondere die Kupferschicht, ist dabei dem zur Luftführung vorgesehenen Innenraum der Anlage zugewandt. Eine solche lufttechnische Anlage kann eine hohe Luftqualität gewährleisten und hat einen reduzierten Reinigungs- und Wartungsaufwand.

Ein zusätzlicher Aspekt der Erfindung betrifft ein Verfahren zur Herstellung einer zuvor beschriebenen Beschichtung bzw. die Herstellung eines zuvor beschriebenen Stahlbandes. Um eine kostengünstige großtechnische Herstellung der Beschichtung zu ermöglichen, wird die Kupferschicht bevorzugt durch elektrochemische Abscheidung, chemische Gasphasenabscheidung oder durch physikalische Gasphasenabscheidung, insbesondere Sputterdeposition oder Plasmaverdampfung, hergestellt.

Ein weiterer Aspekt der Erfindung betrifft eine Beschichtung oder ein Stahlband hergestellt in einem zuvor beschriebenen Verfahren.

Die Wirksamkeit einer beispielhaften, nicht einschränkend auszulegenden, Beschichtung wird anhand der folgenden Versuche und Figuren gezeigt:

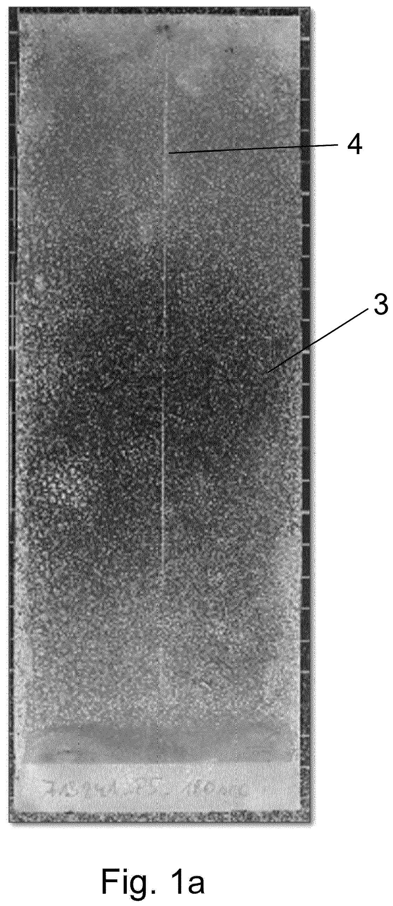

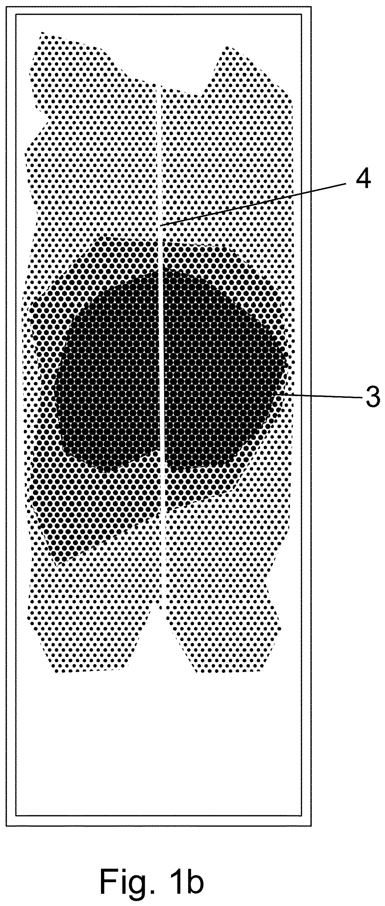

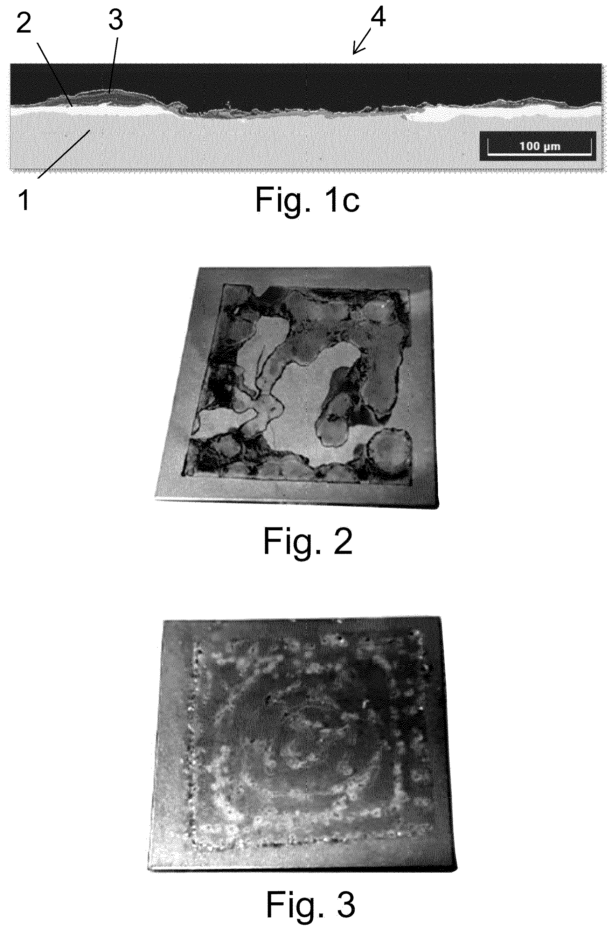

Figur 1 a zeigt eine Probe der ersten Probenserie nach der Korrosionsprüfung nach 28 Tagen.
Fig. 1 b zeigt eine schematische Darstellung der Kupferbelegung (Bildanalyse) der Probe aus Fig. 1 a.
Fig. 1 c zeigt eine Fotografie eines Querschnitts durch eine Probe der ersten Probenserie im Bereich eines korrodierten Ritzes.
Figur 2 zeigt das Bakterienwachstum auf Referenz 1 nach 24 Stunden.
Figur 3 zeigt das Bakterienwachstum auf Referenz 2 nach 24 Stunden.
Figur 4 a zeigt die Ergebnisse der mikrobiologischen Untersuchungen der ersten Probenserie.

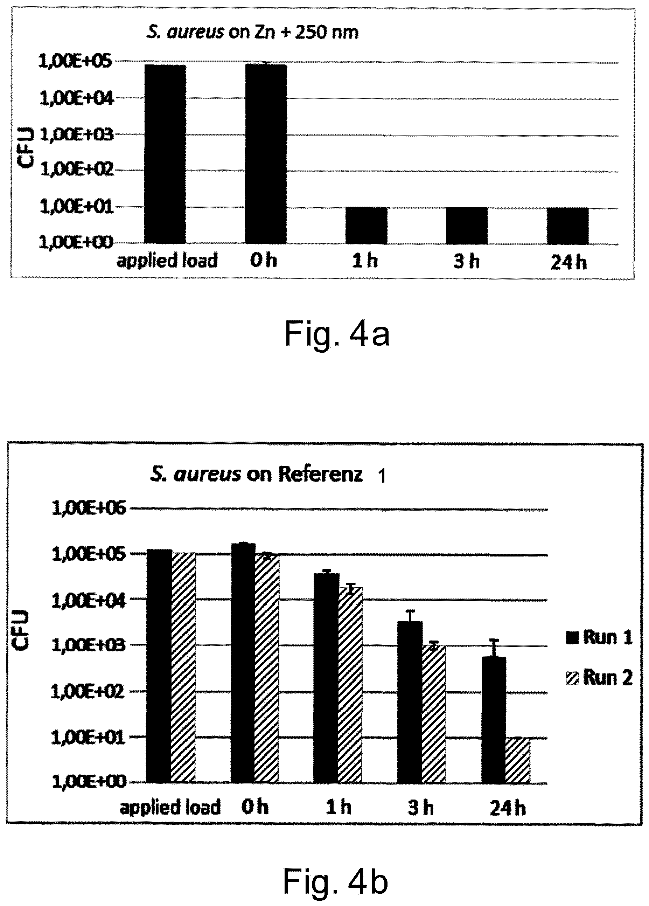

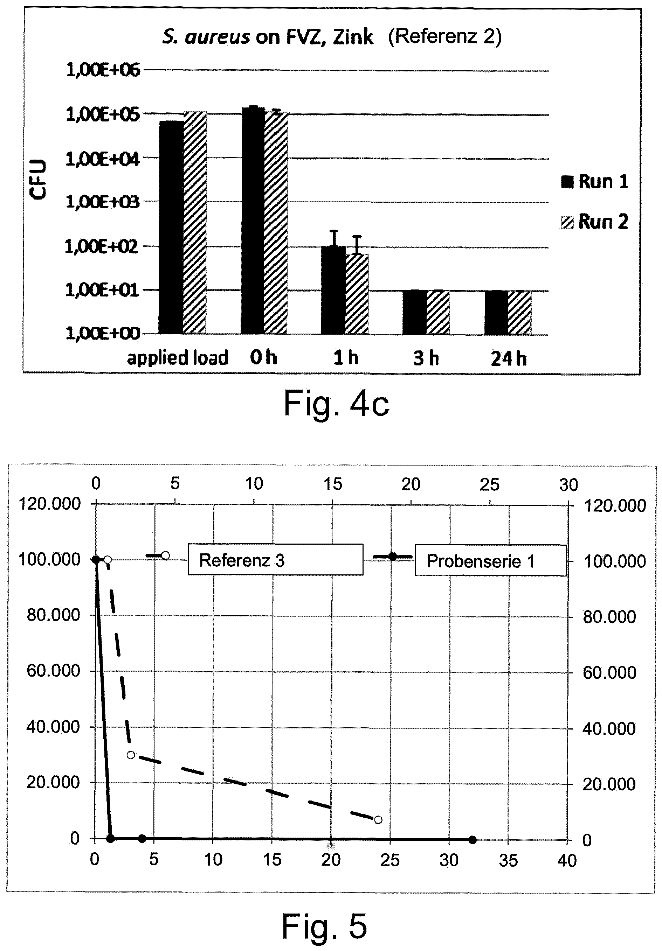

Figur 4 b zeigt die Ergebnisse der mikrobiologischen Untersuchungen mit Referenz 1.
Figur 4 c zeigt die Ergebnisse der mikrobiologischen Untersuchungen mit Referenz 2.
Figur 5 zeigt den Vergleich der mikrobiologischen Untersuchungen zwischen den Proben der ersten Probenserie und Referenz 3.

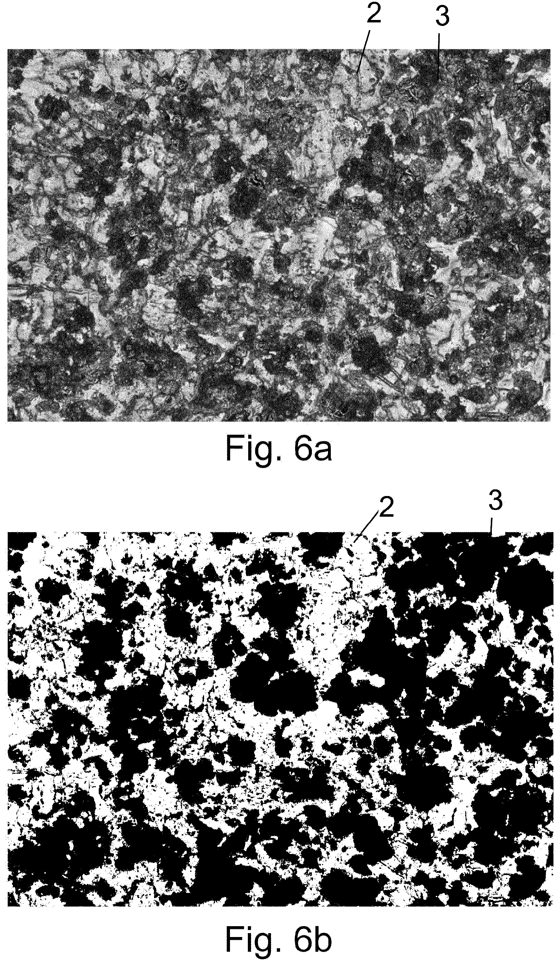

Figur 6 a zeigt eine lichtmikroskopische Aufnahme einer Probe.
Figur 6 b zeigt eine schematische Darstellung der Kupferbelegungen (Bildanalyse) der Probe aus Fig. 6 a.

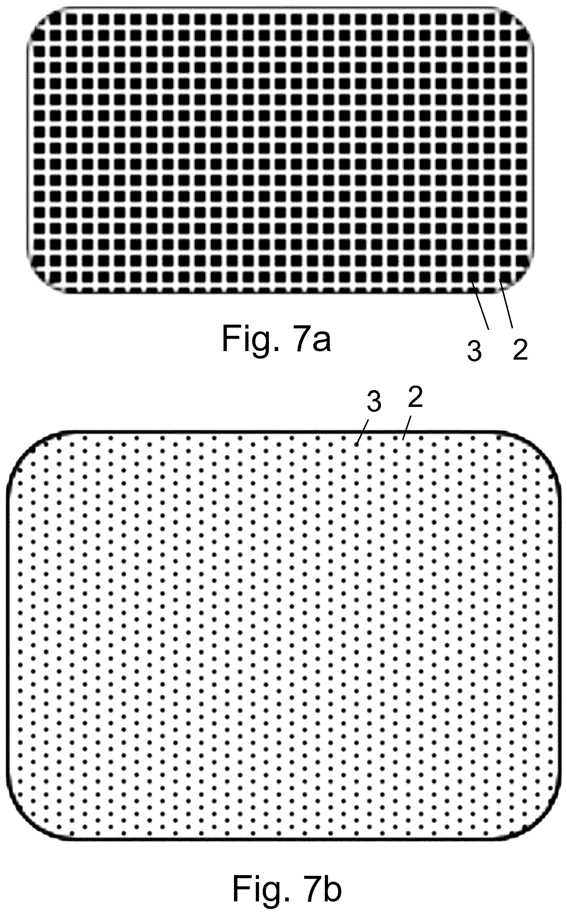

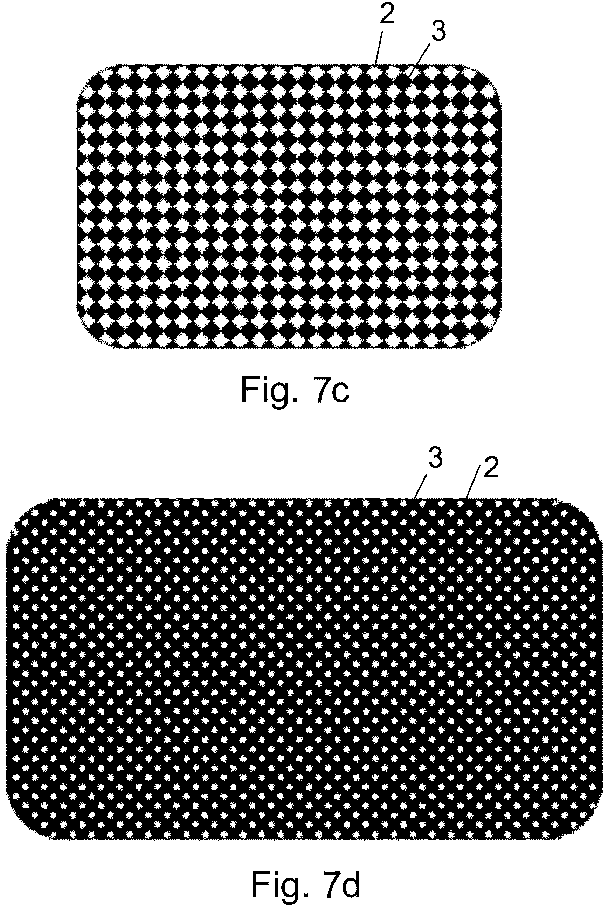

Figur 7 a zeigt eine schematische Darstellung einer Beschichtung mit rasterförmigen Durchbrechungen.
Figur 7 b zeigt eine schematische Darstellung einer Beschichtung mit netzartigen Durchbrechungen.
Figur 7 c zeigt eine schematische Darstellung einer Beschichtung mit schachbrettartigen Durchbrechungen.
Figur 7 d zeigt eine schematische Darstellung einer Beschichtung mit punktförmigen Durchbrechungen.

### A: Herstellung von Proben

Ein Stahlband 1 wurde durch Feuerverzinken mit einer 7 µm dicken Zinkschicht 2 beschichtet. Anschließend wurden aus den Blechen 20 Proben mit einer Größe von 90 mm * 250 mm geschnitten. Die Proben wurden einer Plasmareinigung unterzogen, wobei Ar bei 5*10⁻³ mbar als Prozessgas verwendet wurde. Die Proben wurden bei 300 V und etwa 450 Watt für 20 Sekunden gereinigt, sodass eine Energiedichte von mindesten 20 J/cm² erreicht wurde. Direkt im Anschluss wurden die 20 Proben mit einer Kupferschicht 3 beschichtet. Dazu wurde Kupfer durch Sputterdeposition auf die Bleche aufgebracht, wobei in den vorliegenden Versuchen 5*10⁻³ mbar Ar bei 300 Watt verwendet wurde.

Es wurden zwei Probenserien hergestellt. 10 Proben wurden mit 180 Sekunden Sputterzeit beschichtet. In dieser ersten Probenserie hatte die Kupferschicht 3 eine durchschnittliche Schichtdicke von 250 nm, wobei die Schichtdicke einen Gradienten von 100 nm bis 300 nm aufwies. In Figur 1 b sind von außen nach innen die Bereiche mit einer Schichtdicke von 100 nm bis 200 nm, von 200 nm bis 250 nm und von 250 nm bis 300 nm abgegrenzt dargestellt. Die 10 Proben der zweiten Probenserie wurden mit 300 Sekunden Sputterzeit beschichtet. Die durchschnittliche Schichtdicke der Kupferschicht 3 lag in dieser Gruppe bei 900 nm und hatte einen Gradienten von 700 nm bis 1300 nm. Um den Einfluss von Beschädigungen der Beschichtung auf das Korrosionsverhalten des Stahlblechs 1 prüfen zu können, wurde die Beschichtung mit einem Ritz 4 versehen, der bis in den Stahl reichte.

Figur 6 a zeigt eine lichtmikroskopische Aufnahme der Oberfläche einer Probe der ersten Probenserie, wobei die dunklen Bereiche die Kupferschicht 3 zeigen und die hellen Bereiche die durch die Durchbrechungen sichtbare Zinkschicht 2. Die Durchbrechungen haben eine Fläche von ca. 46 % der Oberfläche der Beschichtung. In der dargestellten Ausführungsform sind die Durchbrechungen schwammstrukturartig ausgebildet. Der Durchmesser der Durchbrechungen liegt in einem Bereich von etwa 1 µm bis 500 µm.

Figur 6 b zeigt die Probe aus 6 a in einer schematischen Ansicht. Dabei zeigt sich die schwammstrukturartige Form der Durchbrechungen noch deutlicher.

Figur 7 a bis d zeigen jeweils schematische Ansichten von alternativen beispielhaften Beschichtungen, wobei die Durchbrechungen gleichmäßig und regelmäßig angeordnet sind. Die rasterförmigen Durchbrechungen aus Figur 7a und die netzartigen Durchbrechungen aus Figur 7 b können erhalten werden, indem während dem Aufbringen der Kupferschicht 3 ein Gitter bzw. ein Netz auf der Zinkschicht 2 angeordnet wird.

### B: Vorbereitung der Proben für die Untersuchungen

Um die Bedingungen in einer lufttechnischen Anlage nachzustellen, wurden die Proben zunächst gemäß DIN EN ISO 6270:2-2018 einer KFW Bewitterung ausgesetzt. Für diese Kondenswasser Wechselklima Prüfung wurden die Proben für 8 Stunden bei 40 °C und 100 % Luftfeuchtigkeit betaut. Anschließend wurde die Klimakammer geöffnet und die Heizung abgestellt, sodass die Proben bei Raumbedingungen abtrocknen. Ein Zyklus dauerte 24 Stunden. Vor der Durchführung der mikrobiologischen Untersuchungen wurden die Proben 7 Zyklen unterzogen. Für die Untersuchung der Korrosionsbeständigkeit wurden ein unbeschichtetes Stahlband (Referenz 1) und ein feuerverzinktes Stahlband (Referenz 2) jeweils einem Zyklus ausgesetzt. Eine Probe der ersten Probenserie wurde für die Untersuchung der Korrosionsbeständigkeit 28 Zyklen ausgesetzt.

### B: Durchführung der Untersuchungen

Die Untersuchung der mikrobiellen Wirksamkeit der Beschichtung erfolgte nach ISO 22196. Als Vergleiche für die Untersuchung wurden unbeschichtetes Kaltband (Referenz 1), feuerverzinktes Stahlband (Referenz 2) und mit einer handelsüblichen antimikrobiellen Beschichtung versehenes Stahlband (Referenz 3) verwendet. In einem Run wurden dabei jeweils 3 Referenzproben untersucht.

Die Korrosion wurde optisch bewertet.

### C: Ergebnisse der Untersuchungen

Figur 1 a zeigt, dass in dem Bereich des Blechs, der mit der Kupferschicht 3 beschichtet ist, keine Korrosion beobachtet werden konnte.

Die Figuren 1 a und c zeigen, dass die Beschichtung der ersten Probenserie bereits einen sehr guten Korrosionsschutz bietet. Auf der Beschichtung bildete sich eine schützende Oberfläche aus Oxiden aus. Figur 1 c zeigt das Stahlblech 1, die direkt auf dem Stahlblech 1 angeordnete Zinkschicht 2 und die direkt auf der Zinkschicht angeordnete Kupferschicht 3. Im Bereich des Ritzes 4 ist das Stahlband 1 von einer Schicht 5 aus Zinkoxid und Kupferoxid bedeckt. Dies bestätigt, dass bei Beschädigungen in der Beschichtung im Bereich des Ritzes 4 die schützende Oberfläche aus Oxiden rasch nachgebildet wurde und eine ungewollte Korrosion so vermieden werden konnte.

Dem gegenüber zeigen die Bleche der Referenz 1 in Figur 2 und der Referenz 2 in Figur 3 bereits nach einem Zyklus deutliche Korrosionsspuren und mikrobiellen Befall.

Die Figuren 4 a bis 4 c zeigen die Ergebnisse der mikrobiellen Untersuchungen. Die Mittelwerte der Anzahl lebensfähiger Bakterien pro Oberfläche sind auf einer logarithmischen Skala dargestellt. 0 h zeigt die Anzahl der lebensfähigen Bakterien unmittelbar nach der Inokulation aus der Probe. 1 h, 3 h und 24 h zeigen die Anzahl der lebensfähigen Bakterien nach den verschiedenen Inkubationszeiten auf der Probe.

Die Proben der ersten Probenserie führten bereits nach einer Stunde zu einer Reduktion der Keimzahl um 100%. Auf dem unbeschichteten Kaltband (Referenz 1) wurde das Wachstum von Staphylococcus aureus nur geringfügig eingeschränkt und eine Reduktion um 100 % wurde erst nach 24 Stunden erreicht. Auch auf dem verzinkten Stahlband (Referenz 2) wurde eine Reduktion der Keimzahl um 100% erst nach 3 Stunden beobachtet.

Figur 5 zeigt den Vergleich zwischen der mikrobiellen Wirkung der Probe und der Referenz 3. Auch hier zeigte sich, dass durch die Proben eine deutlich raschere Reduktion der Keimzahl erreicht wurde. Innerhalb einer Stunde konnten keine lebensfähigen Bakterien mehr nachgewiesen werden. Dasselbe Ergebnis zeigte sich auf bei den Proben der zweiten Probenserie. Im Gegensatz dazu verringerte sich die Keimzahl bei Referenz 3 zwar, allerdings waren zu jedem untersuchten Zeitpunkt lebensfähige Keime nachweisbar.

Die Versuche zeigen, dass die Beschichtung einerseits eine hohe Korrosionsbeständigkeit und andererseits auch eine ausgezeichnete antimikrobielle Wirkung aufweist. Durch die Möglichkeit die Beschichtung auf ein durchlaufendes Stahlband aufzubringen, kann die Beschichtung großflächig und kostengünstig hergestellt werden. Die Beschichtung eignet sich daher besonders für die Verwendung in lufttechnischen Anlagen und kann dazu beitragen dauerhaft eine hohe Luftqualität zu erhalten.

## Patentansprüche

1. Beschichtung für Metall, insbesondere für ein Stahlband (1), umfassend eine Zinkschicht (2) zur Anordnung direkt auf der Oberfläche des Stahlbandes (1) und eine auf der Zinkschicht (2) angeordnete Kupferschicht (3), wobei die Kupferschicht (3) Durchbrechungen aufweist, sodass die Zinkschicht (2) nur teilweise von der Kupferschicht (3) bedeckt ist.

2. Beschichtung nach Anspruch 1, wobei in den Durchbrechungen Zinkoxid und/oder Kupferoxid ausgebildet ist und/oder wobei auf der Oberfläche der Beschichtung Kupferoxid und Zinkoxid angeordnet sind.

3. Beschichtung nach einem der Ansprüche 1 bis 2, wobei die Durchbrechungen schwammstrukturartig ausgebildet sind.

4. Beschichtung nach einem der Ansprüche 1 bis 3, wobei die Durchbrechungen regelmäßig und/oder gleichmäßig in der Kupferschicht verteilt angeordnet sind.

5. Beschichtung nach einem der Ansprüche 1 bis 4, wobei die Fläche der Durchbrechungen 10 % bis 80 %, insbesondere 40 % bis 70 %, vorzugsweise 45 % bis 55 %, der Oberfläche der Beschichtung aufweist.

6. Beschichtung nach einem der Ansprüche 1 bis 5, wobei die Kupferschicht (3) eine Schichtdicke von 30 nm bis 5000 nm, bevorzugt 50 nm bis 1500 nm, insbesondere von 100 nm bis 1300 nm, besonders bevorzugt von 250 nm bis 900 nm, aufweist.

7. Beschichtung nach einem der Ansprüche 1 bis 6, wobei die Zinkschicht (2) eine Schichtdicke von 5 µm bis 15 µm, insbesondere von 7 µm bis 10 µm, aufweist.

8. Stahlband umfassend eine Beschichtung nach einem der Ansprüche 1 bis 7, wobei die Zinkschicht (2) direkt auf dem Stahlband (1) angeordnet ist.

9. Lufttechnische Anlage, insbesondere enthaltend Elemente aus Stahl oder Stahlbändern (1) nach Anspruch 8, umfassend eine Beschichtung nach einem der Ansprüche 1 bis 7, wobei die Beschichtung, insbesondere die Kupferschicht (3), dem zu Luftführung vorgesehenen Innenraum der Anlage zugewandt ist.

10. Verfahren zur Herstellung einer Beschichtung nach einem der Ansprüche 1 bis 7 oder eines Stahlbandes (1) nach Anspruch 8, wobei die Kupferschicht (3) durch elektrochemische Abscheidung, chemische Gasphasenabscheidung oder durch physikalische Gasphasenabscheidung hergestellt wird, wobei die Kupferschicht (3) bevorzugt durch physikalische Gasphasenabscheidung, vorzugsweise Sputterdeposition oder Plasmaverdampfung, hergestellt wird.

11. Beschichtung hergestellt in einem Verfahren nach Anspruch 10.

12. Stahlband hergestellt in einem Verfahren nach Anspruch 10.
